# FASCICULE DE BREVET EUROPEEN

(11) **EP 0 485 281 B1**
(45) Date de publication et mention de la délivrance du brevet: **29.06.1994**
(21) Numéro de dépôt: 91402969.9
(22) Date de dépôt: 06.11.1991
(51) Int. Cl.: H05K 7/20

(54) **Dispositif de ventilation pour une armoire électronique**
Belüftungsvorrichtung für einen elektronischen Schrank
Ventilation device for an electronic cabinet

(30) Priorité: 07.11.1990 FR 9013797
(43) Date de publication de la demande: 13.05.1992
(73) Titulaire: MATRA COMMUNICATION, 29101 Quimper (FR)
(72) Inventeur: Lassalle, Michel, F-78000 Versailles (FR); Puzenat, Jean-Pierre, F-78280 Guyancourt (FR); Tessier, Claude, F-28200 Chateaudun (FR); Vilair, Daniel, F-78910 Orgerus (FR)
(74) Mandataire: Fruchard, Guy

(56) Documents cités:
- EP-A- 0 059 410
- WO-A-86/03648
- GB-A- 2 202 681
- US-A- 4 758 925
- IBM TECHNICAL DISCLOSURE BULLETIN, vol. 17, no. 9, Février 1975, NEW YORK US pages 2529 - 2530; J.R. HAMMER AND R.L. SYLER: 'Ventilation system for data processing systems'
- ELEKTROTECHNIK, vol. 70, no. 22, 16 Décembre 1988, WURZBURG DE pages 48 - 50; 'Manche mögen's kühl'

## Description

La présente invention concerne un dispositif de ventilation pour une armoire électronique.

On sait qu'une grande partie de la puissance électrique consommée par une armoire électronique, par exemple une armoire contenant des unités de traitement de signaux d'un système de radio-communication, est dissipée sous forme de chaleur. Afin d'éviter une élévation de température anormale qui perturberait le fonctionnement des circuits électroniques il est donc nécessaire de prévoir une ventilation de l'armoire.

On connaît, notamment des documents EP-A-59 410 et GB-A-2.202.681 des armoires électroniques dans lesquelles les cartes électroniques portant les circuits électroniques sont disposées verticalement selon des sous-ensembles à l'intérieur de l'armoire et la ventilation est assurée en prévoyant une circulation d'air à partir de la partie inférieure de l'armoire. Le flux d'air de ventilation traverse l'armoire sur toute sa hauteur et balaye l'ensemble des cartes électroniques disposées dans l'armoire. Compte tenu des pertes de charge qu'implique la traversée de l'ensemble de l'armoire, il est généralement nécessaire de prévoir un organe d'extraction disposé à la partie supérieure de l'armoire afin d'augmenter le débit d'air à l'intérieur de l'armoire. La disposition d'un ou de plusieurs extracteurs d'air à la partie supérieure de l'armoire pour assurer un écoulement suffisant à l'intérieur de l'ensemble de l'armoire implique une puissance importante pour ces extracteurs et résulte en un encombrement et un bruit généralement peu satisfaisants. En outre, pour éviter une dispersion du flux d'air il est nécessaire de prévoir à l'arrière de chaque sous-ensemble une cloison qui guide le flux d'air pour le forcer à s'écouler sensiblement verticalement dans le sous-ensemble mais empêche un accès par l'arrière, ce qui complique une intervention lorsqu'une carte est défaillante.

Un dispositif de ventilation selon le préambule de la revendication 1 est aussi connu du IBM Technical Disclosure Bulletin, vol. 17, no. 9, Février 1975, New York, US, pages 2529-2530.

Un but de la présente invention est de proposer un dispositif de ventilation ayant de bonnes performances tout en laissant un accès facile aux cartes électroniques.

En vue de la réalisation de ce but, on prévoit selon l'invention un dispositif de ventilation pour une armoire électronique comportant une façade en regard de laquelle sont fixés des sous-ensembles comprenant chacun une multiplicité de cartes électroniques disposées verticalement, des ouvertures de ventilation débouchant dans la façade en-dessous de chaque sous-ensemble, des tôles déflectrices inférieures disposées en-dessous de chaque ouverture et inclinées pour guider vers une direction verticale un flux d'air entrant par une ouverture de ventilation, une cheminée d'évacuation s'étendant verticalement le long d'une paroi de l'armoire électrique opposée à la façade, au moins un sous-ensemble étant équipé d'un conduit de liaison ayant une extrémité adjacente à un bord supérieur du sous-ensemble et une extrémité opposée débouchant dans la cheminée caractérisé en ce que les sous-ensembles sont portés par un panneau pivotant et les conduits de liaison comportent un tronçon fixe fixé à la cheminée et un tronçon mobile fixé au panneau pivotant et venant en regard du tronçon fixe lors de la fermeture du panneau pivotant. Ainsi, la cloison avant de la cheminée assure un guidage du flux vers le conduit de liaison lorsque le panneau pivotant est fermé, et l'accès aux cartes électroniques est totalement libre lorsque le panneau pivotant est ouvert.

Selon une version avantageuse de l'invention, au moins une ouverture de ventilation est équipée d'un organe de ventilation forcée. Indépendamment de l'augmentation du flux de ventilation qui est obtenu dès l'instant où l'on utilise un organe de ventilation forcé, on a remarqué que la disposition de cet organe de ventilation forcée à l'entrée du dispositif de ventilation assure une meilleure répartition du flux d'air entre les différentes cartes électroniques et donc une ventilation plus homogène de l'armoire électronique.

Selon un mode de réalisation préféré de l'invention le dispositif comporte en outre un organe d'extraction à l'extrémité supérieure de la cheminée. Ainsi on évite qu'un flux d'air poussé dans la cheminée par un ventilateur de façade ne retourne dans un des sous-ensembles adjacent par le conduit de liaison de ce sous-ensemble.

D'autres caractéristiques et avantages de l'invention apparaîtront encore à la lecture de la description qui suit d'un mode de réalisation particulier non limitatif de l'invention en liaison avec les dessins ci-joints parmi lesquels :

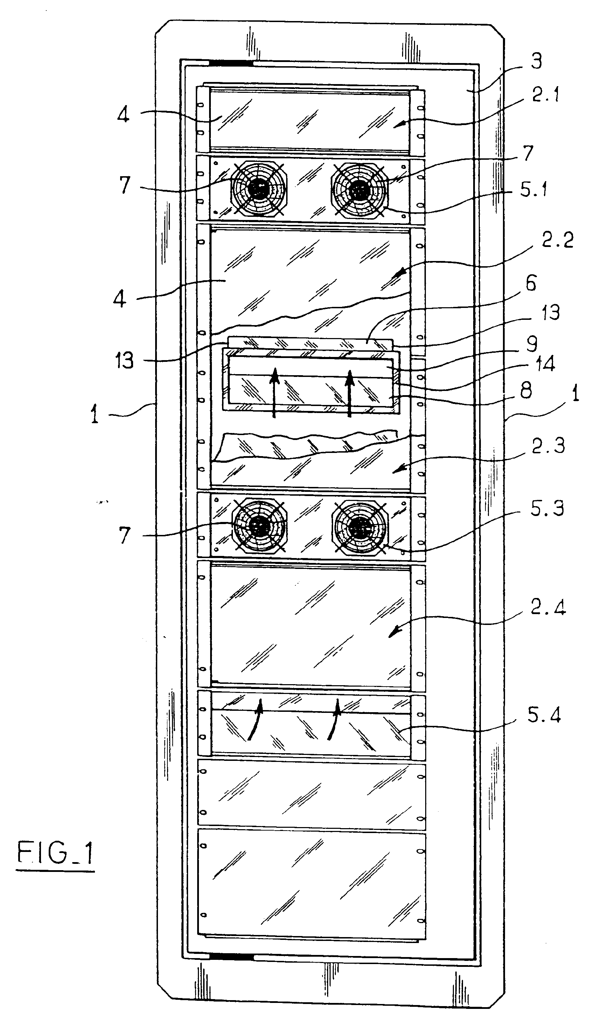

- la figure 1 est une vue de face partiellement écorchée d'une armoire électronique équipée d'un dispositif de ventilation selon l'invention ;

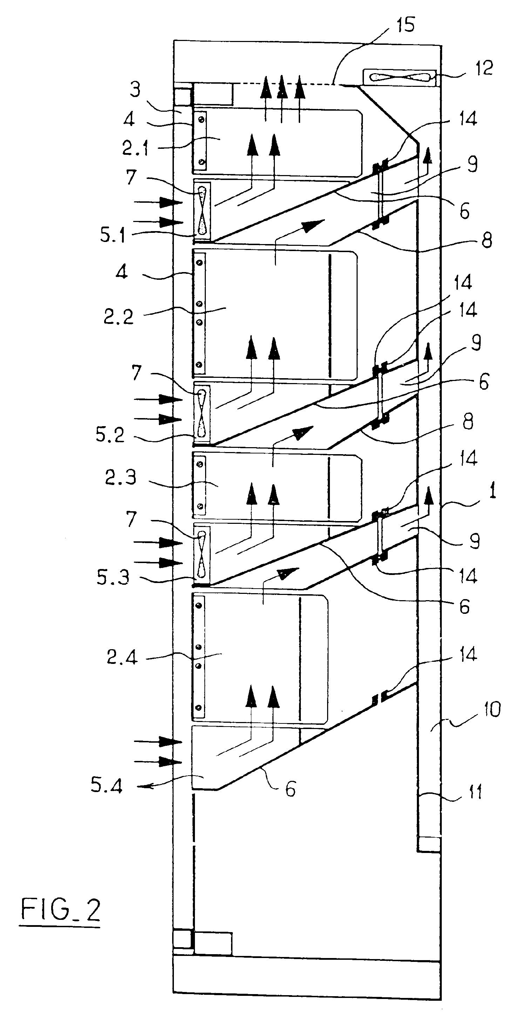

- la figure 2 est une vue en coupe schématique selon un plan vertical.

En référence aux figures, l'armoire électronique comporte de façon habituelle des parois latérales et arrière 1 formées par exemple de tôles soudées à une armature métallique. L'armoire contient une série de sous-ensembles électroniques 2 disposés les uns en-dessous des autres et désignés sur les figures avec un indice, le sous-ensemble 2.1 étant disposé à la partie supérieure de l'armoire électronique, le sous-ensemble 2.2 étant disposé immédiatement en-dessous, etc. Chaque sous-ensemble 2 comporte une multiplicité des cartes électroniques disposées verticalement les unes à côté des autres.

Dans le mode de réalisation préféré illustré, les sous-ensembles 2 sont portés par un cadre pivotant 3 et chaque sous-ensemble est recouvert sur sa partie avant par une plaque pleine 4. Le cas échéant, la façade avant de l'armoire est protégée par une tôle ajourée non représentée assurant une protection contre les perturbations électromagnétiques.

Le dispositif de ventilation selon l'invention comporte des ouvertures de ventilation 5 débouchant dans la façade en-dessous de chaque sous-ensemble et des tôles déflectrices inférieures 6 disposées en-dessous de chaque ouverture 5 et inclinées vers le haut pour guider vers une direction verticale un flux d'air entrant par une ouverture de ventilation 5.

Dans le mode de réalisation illustré, les ouvertures de ventilation 5.1, 5.2 et 5.3 sont équipées de deux organes de ventilation forcée 7 tandis que l'ouverture de ventilation 5.4 est simplement laissée libre. Les tôles de ventilation inférieure 6 de chaque sous-ensemble sont de préférence associées à une seconde tôle déflectrice venant affleurer la partie supérieure du sous-ensemble située immédiatement en-dessous pour former un conduit de liaison 9 ayant une extrémité adjacente à un bord supérieur du sous-ensemble considéré et une extrémité opposée débouchant dans une cheminée d'évacuation 10 s'étendant verticalement le long d'une paroi de l'armoire électrique opposée à la façade. La cheminée d'évacuation 10 est par exemple réalisée au moyen d'une tôle 11 s'étendant parallèlement au panneau arrière 1 de l'armoire électronique. La cheminée 10 débouche de préférence dans la face supérieure de l'armoire électronique et est équipée d'un extracteur 12 qui sert uniquement à améliorer l'écoulement dans la cheminée 10 et éviter un bouclage des flux d'air provenant de différents sous-ensembles. Cet extracteur peut donc être d'encombrement très faible et tourner à une vitesse relativement lente ne générant pas de bruit.

De préférence, les conduits de liaison 9 comportent des parois latérales 13 pour former un conduit tubulaire. Les conduits de liaison 9 sont découpés en deux tronçons, l'un des tronçons étant solidaire des sous-ensembles pour pivoter avec le cadre pivotant 3 auquel ceux-ci sont fixés et l'autre tronçon étant solidaire de la cheminée 10. Lors de la fermeture de l'armoire, l'étanchéité entre les deux tronçons de chaque conduit 9 est assurée par tout moyen approprié, par exemple par des joints souples 14.

On remarquera qu'il n'est pas nécessaire que tous les sous-ensembles soient associés à la cheminée par un conduit de liaison 9. En particulier, dans le mode de réalisation illustré, le sous-ensemble 2.1 disposé à la partie supérieure de l'armoire est ventilé par un courant d'air direct qui s'échappe à travers une tôle perforée formant une partie de la face supérieure de l'armoire.

De même, bien qu'une ventilation forcée soit souvent préférée pour augmenter le débit d'air à travers un sous-ensemble, on notera que la ventilation forcée pour un certain nombre de sous-ensembles génère en liaison avec la cheminée 10 un flux secondaire qui peut s'avérer suffisant pour ventiler un sous-ensemble particulier. Dans l'exemple décrit, le sous-ensemble 2.4 est ainsi associé à un conduit de liaison 9 dans lequel les organes de ventilation forcés 7 associés aux sous-ensembles 2.2 et 2.3 créent un flux secondaire très supérieur au flux d'air qui serait obtenu par une simple convection naturelle. Ce flux secondaire peut être important, en particulier si l'on choisit de façon convenable la section, et le cas échéant l'orientation des conduits de liaison 9 par rapport à la cheminée 10.

## Revendications

1. Dispositif de ventilation pour une armoire électronique comportant une façade en regard de laquelle sont fixés des sous-ensembles (2) comprenant chacun une multiplicité de cartes électroniques disposées verticalement, des ouvertures de ventilation (5) débouchant dans la façade en-dessous de chaque sous-ensemble (2), des tôles déflectrices inférieures (6) disposées en-dessous de chaque ouverture (5) et inclinées pour guider vers une direction verticale un flux d'air entrant par une ouverture de ventilation, une cheminée d'évacuation (10) s'étendant verticalement le long d'une paroi de l'armoire électrique opposée à la façade, au moins un sous-ensemble étant équipé d'un conduit de liaison (9) ayant une extrémité adjacente à un bord supérieur du sous-ensemble et une extrémité opposée débouchant dans la cheminée (10) caractérisé en ce que les sous-ensembles sont portés par un panneau pivotant (3) et les conduits de liaison (9) comportent un tronçon fixe fixé à la cheminée (10), et un tronçon mobile fixé au panneau pivotant (3) et venant en regard du tronçon fixe lors de la fermeture du panneau pivotant.

2. Dispositif de ventilation selon la revendication 1, caractérisé en ce que l'une des parois d'un conduit de liaison (9) est formée par la tôle déflectrice inférieure (6) de l'ouverture immédiatement supérieure.

3. Dispositif de ventilation selon la revendication 1 ou la revendication 2, caractérisé en ce qu'au moins une ouverture de ventilation est équipée d'un organe de ventilation forcée (7).

4. Dispositif de ventilation selon la revendication 3 caractérisé en ce qu'il comporte un organe d'extraction (12) à l'extrémité supérieure de la cheminée (10).

## Patentansprüche

1. Belüftungsvorrichtung für einen Elektronikschrank, mit einer Vorderfront, der gegenüberliegend Teilsysteme (2) befestigt sind, deren jedes eine Mehrzahl von vertikal angeordneten gedruckten Schaltungen umfaßt, mit Belüftungsöffnungen (5), die unterhalb jedes Teilsystems in die Vorderfront münden, mit unteren Ablenkblechen (6), die unterhalb jeder Öffnung (5) angeordnet und so geneigt sind, daß sie einen durch eine Belüftungsöffnung eintretenden Luftstrom in eine vertikale Richtung lenken, und mit einem Abzugsschacht (10), der sich vertikal entlang einer der Vorderfront gegenüberliegenden Wand des Schaltschranks erstreckt, wobei zumindest ein Teilsystem mit einer Verbindungsleitung (9) ausgestattet ist, die ein an eine Oberkante des Teilsystems angrenzendes Ende und ein diesem entgegengesetztes, in den Schacht (10) mündendes Ende hat, dadurch gekennzeichnet, daß die Teilsysteme von einer Schwenkplatte (3) getragen sind und daß die Verbindungsleitungen (9) einen an dem Schacht (10) befestigten feststehenden Abschnitt und einen mobilen Abschnitt haben, der an der Schwenkplatte (3) befestigt ist und beim Schließen der Schwenkplatte in eine dem feststehenden Abschnitt gegenüberstehende Lage gelangt.

2. Belüftungsvorrichtung nach Anspruch 1, dadurch gekennzeichnet, daß die eine der Wände einer Verbindungsleitung (9) durch das untere Ablenkblech (6) der unmittelbar darüberliegenden Öffung gebildet ist.

3. Belüftungsvorrichtung nach Anspruch 1 oder 2, dadurch gekennzeichnet, daß zumindest eine Belüftungsöffnung mit einem Zwangsbelüftungsorgan (7) ausgestattet ist.

4. Belüftungsvörrichtung nach Anspruch 3, dadurch gekennzeichnet, daß diese am oberen Ende des Schachts (10) ein Sauggebläseorgan (12) umfaßt.

## Claims

1. A ventilation device for an electronic cabinet comprising a front portion, opposite which are fixed sub-assemblies (2) each comprising a multiplicity of vertically disposed electronic circuit boards, ventilation openings (5) opening in the front portion below each sub-assembly (2), lower deflector plates (6) disposed below each opening (5) and inclined to guide towards a vertical direction a flow of air which enters by way of a ventilation opening, a discharge shaft (10) extending vertically along a wall of the electrical cabinet, which is opposite to the front portion, at least one sub-assembly being equipped with a connecting conduit (9) having an end adjacent to an upper edge of the sub-assembly and an opposite end opening into the shaft (10), characterised in that the sub-assemblies are carried by a pivotable panel (3) and the connecting conduits (9) comprise a fixed portion which is fixed to the shaft (10) and a movable portion which is fixed to the pivotable panel (3) and is disposed in a position opposite the fixed portion upon closure of the pivotable panel.

2. A ventilation device according to claim 1 characterised in that one of the walls of a connecting conduit (9) is formed by the lower deflector plate (6) of the opening immediately above.

3. A ventilation device according to claim 1 or claim 2 characterised in that at least one ventilation opening is equipped with a forced ventilation member (7).

4. A ventilation device according to claim 3 characterised in that it comprises an extraction member (12) at the upper end of the shaft (10).
